Europäisches Patentamt

European Patent Office

Office européen des brevets

(19)

(11) Publication number:

**0 253 085**
A1

(12) # EUROPEAN PATENT APPLICATION

(21) Application number: 87106433.3

(22) Date of filing: 29.06.84

(51) Int. Cl.⁴: **G 01 R 31/08,** G 01 M 3/18

(30) Priority: 30.06.83 US 509897
11.04.84 US 599047
24.04.84 US 603485
07.06.84 US 618109

(43) Date of publication of application: 20.01.88
Bulletin 88/3

(84) Designated Contracting States: **AT BE CH DE FR GB IT LI LU NL SE**

(60) Publication number of the earlier application in accordance with Art. 76 EPC: 0133748

(71) Applicant: **RAYCHEM CORPORATION, 300 Constitution Drive, Menlo Park California 94025 (US)**

(72) Inventor: **Brooks, Peter Leonard, 611, Glen Alto, Los Altos California 94022 (US)**
Inventor: **Reeder, Larry Russell, 1182, Littleoak Drive, San Jose California 95129 (US)**
Inventor: **Reed, James Patrick, 1745, Beach Street No. 10, San Francisco California 94123 (US)**
Inventor: **Tolles, Thomas Winton, 3034, Jackson Street, San Francisco California 94115 (US)**
Inventor: **Masia, Michael, 258, Grad Street, Redwood City California 94062 (US)**

(74) Representative: **Benson, John Everett et al, Raychem Limited Intellectual Property Law Department Swan House 37-39, High Holborn, London WC1 (GB)**

(54) Method for detecting and obtaining information about changes in variables.

(57) Method and apparatus for detecting and obtaining information about (particularly locating) an event (E), i.e. a change in a variable, for example a liquid leak. In a preferred embodiment, two conductors (11, 12) follow an elongate path and are connected to each other through a power source, preferably a constant current source (15). In the absence of an event, the two conductors (11, 12) are electrically insulated from each other at all points along the path. When an event (E) occurs, the two conductors (11, 12) become electrically connected at a connection point at which the event occurs, thus completing a test circuit in which a current of known size then flows. When using a constant current source (15), the size of the current does not depend on the resistance of the connection. One of the conductors is a locating member having known impedance characteristics along its length, and by measuring the voltage drop between the connection point and one end of the locating member, the location of the event can be calculated. The voltage drop can conveniently be measured by means of a third conductor which connects, via a high impedance voltmeter (14), the ends of the locating member.

0253085
MPO869

# METHOD FOR DETECTING AND OBTAINING INFORMATION ABOUT CHANGES IN VARIABLES

This invention relates to methods and apparatus for detecting and obtaining information about (particularly locating) changes in variables.

A number of methods have been proposed for detecting and locating changes in variables along an elongate path, e.g. the occurrence of a leak (of water or another liquid or gas), insufficient or excessive pressure, too high or too low a temperature, the presence or absence of light or another form of electromagnetic radiation, or a change in the physical position of a movable member, e.g. a valve in a chemical process plant or a window in a building fitted with a burglar alarm system. Changes of this kind are referred to in this specification by the generic term "event". Reference may be made for example to U. S. Patents Nos. 1,084,910, 2,581,213, 3,248,646, 3,384,493, 3,800,216, and 3,991,413, U.K. Patent No. 1,481,850 and German Offenlegungschriften Nos. 3,001,150.0 and 3,225,742. However, the known methods are expensive, and/or inaccurate, and/or cannot be used when the event causes electrical connection between two conductors through a connection which is of high or indeterminate resistance, e.g. an ionically conductive connecting element.

We have now discovered a simple and accurate method and apparatus for monitoring for the occurrence

0253085
MPO869

of an event, and for detecting and obtaining information about the event upon its occurrence (i.e. as soon as it occurs or at some time after it has occurred). In this method, upon occurrence of the event, at least one electrical connection is made between a source member and a locating member of known impedance characteristics, the connection or connections being effective at a first point at which the event takes place (or whose location is defined by some other characteristic of the event). A current of known size is then driven through the electrical connection(s) and down the locating member to a second point whose location is known. The voltage drop between the first and second points is then measured and the location of the first point can then be determined.

When the occurrence of the event causes a single or very short connection to be made between the locating member and the source member, then the "first point" will be easily identified, since it is the only connection point. However, when the event results in connection at two or more spaced-apart locations and/or over a finite length of the locating member, the "first point", i.e. the point whose location is determined from the measured voltage drop, is some intermediate point (which, if there are connections at two or more spaced-apart locations, may be at a location at which there is no connection between the locating and source members). It is for this reason that the connection to the locating member is referred to herein as being "effective" at the first point.

The invention overcomes one or more of the disadvantages of the known processes. For many uses, a particularly important advantage is that the information obtained can be independent of the impedance of the connection to the locating member, i.e. the information obtained remains the same even if a substantial and unknown change is made in the impedance of the connection.

In one aspect, the invention provides a method for monitoring for the occurrence of an event, and for detecting and obtaining information about the event upon its occurrence, which method comprises providing a system in which, upon occurrence of the event,

(1) electrical connection is made between a locating member and a source member;

the connection to the locating member being effective at a first point whose location is defined by at least one characteristic of the event;

the making of the connection enabling the formation of a test circuit which comprises (a) the connection, (b) that part of the locating member which lies between the first point and a second point having a known location on the locating member, and (c) a power source which causes an electrical current of known size to be transmitted between the first and second points on the locating member; and

the current and the locating member being such that, by measuring the voltage drop between the first and second points, the spatial relationship between the first and second points can be determined;

(2)   the voltage drop between the first and second points is measured; and

(3)   information concerning the event is obtained from the measurement made in step (2).

Preferably the voltage drop between the first and second points is determined by means of a voltage-measuring device which forms part of a reference circuit, the reference circuit comprising

(a)   the voltage-measuring device,

(b)   that part of the locating member which lies between the first and second points, and

(c)   a return member which (i) is electrically connected to the locating member at the second point and at another point on the locating member whose distance from the second point is at least as great as the distance from the second point to the first point, both distances being measured along the locating member, and (ii) is otherwise insulated from the locating member,

the voltage-measuring device having an impedance which is very high by comparison with any unknown part of the impedance of the other components of the reference circuit.

The invention also includes apparatus suitable for carrying out the method of the invention, in particular apparatus comprising

(1)   an elongate locating member whose impedance from one end to any point on the locating member defines the spatial relationship between that end and that point;

(2)   an elongate source member;

(3)   an event-sensitive connection means which, upon occurrence of an event, effects electrical connection between the locating member and the source member, the connection being effective at a first point on the locating member which is defined by at least one characteristic of the event;

(4)   a voltage-measuring device for determining the voltage drop between the first point and a second point which is at one end of the locating member; and

(5)   a power source which is electrically connected to the second point on the locating member and which, in the absence of an event, is not otherwise connected to the locating member, so that, when occurrence of an event causes an electrical connection to be made between the locating and source members, this enables the formation of a test circuit as defined above.

The invention also includes novel elongate articles which can be used as the locating member (and optionally also as the source member) in the method and apparatus of the invention, in particular articles which comprise

(A) an elongate core which is composed of a metal whose temperature coefficient of resistivity averages less than 0.003 per degree Centigrade over the temperature range 0° to 100°C and in which each longitudinal section has a resistance which is from $10^{-4}$ to $10^{4}$ ohms/foot, and

(B) an elongate jacket which is composed of a conductive polymer which electrically surrounds the core, and in which each longitudinal section has a resistance which is at least 100 times the resistance of the core of that longitudinal section at all temperatures from 0° to 100°C.

## BRIEF DESCRIPTION OF THE DRAWING

The invention is illustrated in the accompanying drawing, in which

Figure 1 is a generalized schematic circuit diagram of the method of the present invention,

Figures 2-30 are schematic circuit diagrams of the method and apparatus of the invention,

Figures 30-32 are graphs showing how the voltage
drop between the first and second points
on the locating member can vary in different
systems of the invention, and

Figures 33-38 are diagrammatic cross-sections
through apparatus of the invention.

## DETAILED DESCRIPTION OF THE INVENTION

In the interests of clarity, the following detailed
description of the invention includes sections which
are chiefly or exclusively concerned with a particular
part of the invention.  It is to be understood, however,
that the relationship between different parts of the
invention is of significant importance, and the following
detailed description should be read in the light of
that understanding.  It should also be understood that,
where features of the invention are described in the
context of particular Figures of the drawing, the same
description can also be applied to the invention in
general and to the other Figures, insofar as the
context permits.

## 1.   THE ELECTRICAL CHARACTERISTICS OF THE INVENTION

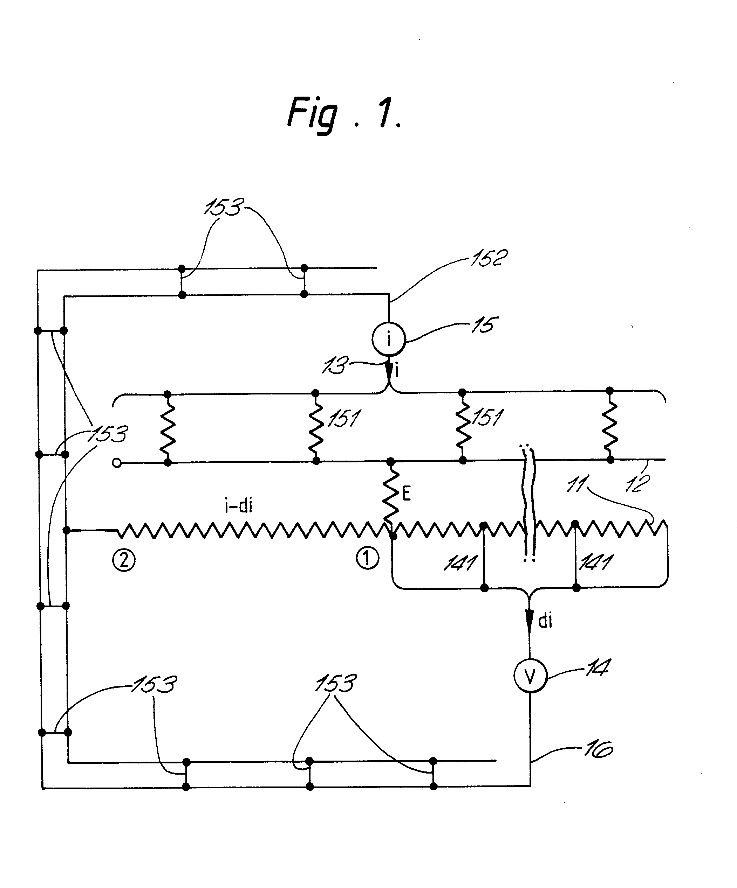

The basic electrical characteristics of the
invention can best be understood by reference to
Figure 1, which schematically represents a substantial
number of the preferred methods and apparatus of the
invention.  In Figure 1, there is an elongate locating
member 11, an elongate source member 12, a voltage-
measuring device 14, a power source 15 and an elongate
return member 16.  The source member is electrically connected, through the power source, to one end of the locating member; in the absence of an event, there is no other electrical connection between the locating member and the source member. Between the source and locating members (but not shown in Figure 1) is an event-sensitive connection means (this term being used to include a continuous event-sensitive connection means and a plurality of spaced-apart event-sensitive connection means) which becomes conductive at any location at which an event takes place. In Figure 1, an event has taken place at a first point 1 which lies somewhere on the locating member, but whose location is otherwise unknown. As a result of the event, an electrical connection E has been made between the locating and source members. The power source 15 is connected via connection means 152 to the locating member at one end thereof, designated by the numeral 2, which is the "second point" in the definitions given above of the method and apparatus of the invention. (The second point could be at any point of known location between the end of locating member 11 and the connection point 1, providing that the voltage-measuring device is arranged to measure the voltage drop between the first and second points.) The power source is also connected to the source member by an auxiliary connection member 13; as schematically indicated by the plurality of connections 151, the connection between the power source and the source member can be made at any one or more points on the source member. Furthermore, these connections can be of any and unknown impedance, providing the power source can drive a known current between the first and second points of the locating member. Thus the making of the connection at point 1 results in the formation of a test circuit which includes the connection, the locating member between points 1 and 2, the power source 15, the auxiliary connection member 13, and (unless a single connection 151 is made between the power source and the source member at the connection point) part of the source member 12. As will be further discussed below, important advantages can be obtained if the only variable in the impedance of the test circuit is the impedance of the connection between the source and locating members. This result can be achieved by making use of a source member which has the same impedance characteristics as the locating member, and an auxiliary member which is connected to the source member only at the end thereof which is remote from point 2.

The voltage-measuring device is connected to the second point 2 on the locating member (via the return member 16) and is also connected to the locating member at one or more points whose distance from the second point is at least as far as the first point 1; as schematically indicated by the plurality of connections 141, these connections must be of known impedance or an impedance which is very small by comparison with the impedance of the voltage-measuring device. Thus the voltage-measuring device forms part of a reference circuit which comprises the device 14, at least that part of the locating member 11 between points 1 and 2, and the return member 16.

The power source 15 and the voltage-measuring device 14 can be connected to the point 2 on the locating member 11 in any convenient way. Thus, as indicated by the plurality of connections 153, the connection member 152 and the return member 16 can be connected to each other at any one or more locations.

It will be seen that the location of point 1 can be calculated if the following are known:-

(a)   the current flowing between points 1 and 2,

(b)   the impedance of the components of the reference circuit,

(c)   the voltage drop measured by the voltage-measuring device,

(d)   the location of point 2, and

(e)   the impedance of the locating member between point 2 and each point on the locating member.

Systems in which these features are known can be provided in a number of different ways. The accuracy with which the first point can be located is limited by the ratio of the impedance of the voltage-measuring device to any unknown part of the impedance of the other components of the reference circuit, and in most cases it is convenient to use components such that the ratio of the impedance of the device to the total impedance of the rest of the reference circuit is very high. Accordingly, these ratios should preferably be at least 100, particularly at least 1,000, especially at least 10,000. It is for these reasons that the connections 141 and 153 in Figure 1 are shown as having low resistance. By contrast, the impedance of the connection between the locating and source members, and the impedance of the other components of the test circuit, do not affect the accuracy of the information obtained; this is an important advantage of the invention.

## 2.   INFORMATION WHICH CAN BE PROVIDED ABOUT AN EVENT

The method of the invention not only detects that a particular event has taken place, but also provides information about the event. In many cases, the information provided about the event is its location, particularly when the event takes place at (or near) the location of the first point. However, the information provided can be other information; for example when the temperature at a particular location is being monitored, one point on the locating member can be identified when the temperature is in one temperature range and another point can be identified when the temperature is in a different temperature range. As just noted, the location of the event may be at, or close to, the first point on the locating member. However, this is not necessarily so; for example, one or more remote event-detecting stations can be connected, electrically or otherwise, to different points on a central locating member, the locations of the connection points being characteristic of the locations of the event-detecting stations. The method of the invention will provide some, but not necessarily all, the desired information about the event. For example, the method can usefully be employed to determine that a given event (e.g. the opening of a valve) has taken place at one or more of a relatively small number of different locations, out of a relatively large number of possible locations for the event, leaving it to visual inspection or some other form of test (which may be a further and different method of the invention) to determine precisely where the event has taken place.

### 3. EVENTS WHICH CAN BE DETECTED, AND EVENT-SENSITIVE CONNECTION MEANS FOR DETECTING THEM

The event which is detected in the method of the invention can be an event which is not desired (a fault) or an event which is desired. The event can be the existence of a particular condition or a change in a single variable, e.g. an increase in pressure above a particular value, or a simultaneous or sequential change in two or more variables, e.g. an increase in pressure accompanied by an increase in temperature. The event can be a change in a variable which lasts for only a very short time, or a change in a variable which is maintained for some minimum time. The event can be of any kind which directly or indirectly permits or causes the current to be transmitted between the first point and the second point on the locating member. As noted above, the information obtained is independent of the impedance of the connection. Thus the connection between the locating and source members can be of any kind, for example an electronic connection (which can be of substantially zero impedance or can have substantial impedance), or an ionic connection resulting from the presence of an electrolyte, or an inductive connection. The change which takes place in order to effect the connection between the locating and source conductors is preferably a reversible change. However, the invention is also useful when the change is a permanent one, so that the apparatus must be replaced or repaired before the system is operational again. The system can be arranged so that it signals an event only while the event is taking place or so that it signals that an event has occurred in the past; in the latter case, the system will normally be arranged so that it can be reset.

Examples of events which can be detected include, but are not limited to, the following.

A. The presence of water or another electrolyte which provides an ionic connection between exposed surfaces of the locating and source members, especially when at least part of at least one of these comprises a metal core surrounded by a conductive polymer. In this case, the event-sensitive connection means can be merely a space between the locating and source members, or it can be a connection member on which the electrolyte collects or which absorbs the electrolyte.

B. The existence of a temperature which is below a first temperature $T_1$ or above a second temperature $T_2$. In one apparatus for detecting such a condition, the locating and source members are physically contacted by a connecting member which insulates them from each other at $T_1$ and connects them to each other at $T_2$. For example, at least part of the connecting member can comprise (a) a first material and (b) a second material which is dispersed in the first material and which forms mobile ionic species when the temperature changes from $T_1$ to $T_2$. Thus the first material can be one which changes phase, e.g. melts, when the temperature changes from $T_1$ to $T_2$.

In another apparatus for detecting a temperature change, the locating and source members are separated from each other by a deformable insulating medium, e.g. an insulating medium which is at least in part a fluid, e.g. air, and the apparatus comprises a connecting member which changes shape when the temperature changes from $T_1$ to $T_2$, thus forcing the members into contact, by deforming the insulating medium, or, if the connecting member is itself conductive, by forcing the connecting member through the insulating medium to connect the members. The connecting member can comprise a heat-recoverable polymer or a heat-recoverable memory metal or can comprise a bimetallic strip. The term "memory metal" is used herein to denote one of the metal alloys (in particular various brass alloys and nickel-titanium alloys) which exist in a strong austenitic state above a transformation temperature and in a weak martensitic state below that transformation temperature, and which, if fabricated in a first shape in the austenitic state, can be cooled to the martensitic state and then deformed, will retain the deformed configuration until reheated to the austenitic state, when they will revert (or attempt to revert) towards the original shape. Where a reversible effect is desired, a particular type of memory metal must be employed or the memory metal member can be combined with a conventional spring metal member to produce a connecting member which will connect the locating and source members either when the temperature rises above the transformation temperature or when it falls below the transformation temperature (as more specifically discussed below, in connection with the Figures). For further details of memory metals and devices comprising them, reference may be made for example to U.S. Patents Nos. 3,174,851, 3,740,839, 3,753,700, 4,036,669, 4,144,104, 4,146,392, 4,166,739 and 4,337,090, the disclosures of which are incorporated herein by reference.

C. A change in the concentration of a particular substance, which may for example be a gas, a liquid or a solid dispersed in a gas or a liquid, the locating and source members being physically contacted by a connecting member which insulates them prior to said change, and which electrically connects them as a result of said change.  The electrical connection can for example result from a chemical reaction between the substance and at least part of the connecting member, thus for example releasing a mobile ionic species.  Alternatively, the presence of the substance can for example cause at least part of the connecting member to change shape, as for example where the substance causes swelling of a conductive polymer connecting member or where the substance is a solvent for an adhesive or polymeric retaining member which maintains a spring member in a deformed state, or can change the state of an ionization chamber, for example in a smoke detector, or the transmissivity of a photoelectric cell, which in turn will cause a switch to connect the locating and return members.

D.    A change from a first pressure $P_1$, to a second pressure, $P_2$, the locating and source members being contacted by a connecting member which insulates them from each other at pressure $P_1$ but permits electrical connection between them at pressure $P_2$.  For example, the connecting member can be deformable, e.g. composed of air or other fluid insulating material.

E.    A change in the intensity or other characteristic of electromagnetic radiation, the locating and source members being physically contacted by a connecting member which is exposed to said radiation, which insulates them from each other prior to said change and which electrically connects them to each other after said change.  Suitable apparatus could for example include a photoelectric cell.

F.   A change in the position of a valve, e.g. in a refinery or other chemical process plant, thus changing the position of a switch in a connecting member between the locating and source members.

## (4)   SETTING A MAXIMUM FOR THE IMPEDANCE OF THE CONNECTION BETWEEN THE SOURCE AND LOCATING MEMBERS

In some situations, it is desirable that the system should not signal an event when the connection between the source and locating members has an impedance over some preselected value, for example when the presence of a small amount of electrolyte makes a very high resistance connection.  In these situations, the system is preferably such that when the current in the test circuit is below a preselected value, the occurrence of an event is not signalled.

This is particularly important when, as is preferred, the power source is a fixed current source, since the voltmeter may otherwise provide a false indication of the location of the event.  This is because the fixed current source will only provide the expected fixed current if the compliance voltage of the power source is high enough to drive the fixed current through the test circuit.  Therefore, if the impedance of the test circuit is too high, the actual current in the test circuit will be less than the "fixed" current, and the voltage drop between the first and second points on the locating member will not correctly represent the location of the first point.

actual current in the test circuit will be less than
the "fixed" current, and the voltage drop between the
first and second points on the locating member will not
correctly represent the location of the first point.
This difficulty can be avoided by blanking out the
display on (or associated with) the voltmeter if the
current is below the fixed value or by including in the
test circuit a current switch which will prevent
currents below the "fixed" current from flowing in the
test circuit.

Even when the information provided about the event
is correct, delivery of that information may be undesirable.  Under these circumstances, when using a constant
current source, the output voltage of the source can be
monitored, and delivery of information prevented unless
the output voltage is within a predetermined range.
Similarly, when using a constant voltage source, the
current in the test circuit can be monitored, and
delivery of information prevented (for example by use
of a current switch or by blanking out the display on,
or associated with, the voltmeter) unless the current
is within a predetermined range.

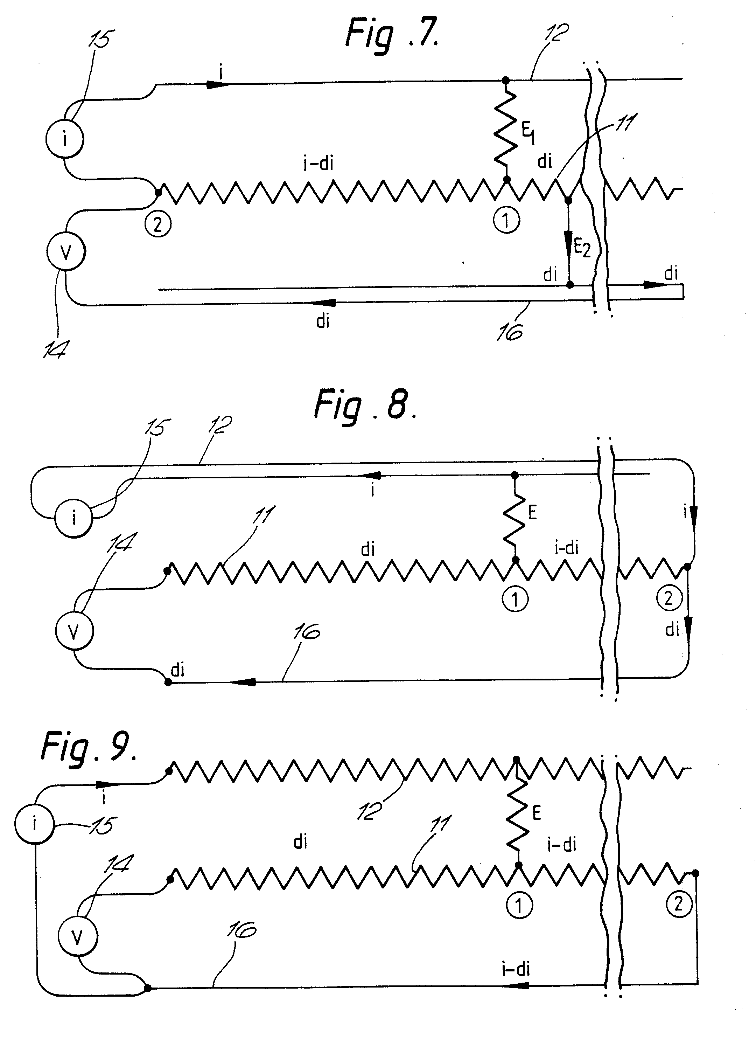

In a system of this kind, the critical parameter
(in determining whether or not the information is
delivered) is the impedance of the test circuit, and it
is, therefore, desirable that the only variable impedance
in the test circuit should be the impedance of the
connection.  This can be achieved by including in the
test circuit a component which (1) is connected in
series with that part of the locating member which lies
between the first and second points, and (2) has an
impedance substantially equal to the difference between the total impedance of the locating member and the impedance of that part of the locating member which lies between the first and second points. Such a component is preferably provided by making use of a source member which has the same impedance characteristics as the locating member, and by ensuring that the test circuit includes complementary portions of the source and locating members which, taken together, have the same impedance wherever the connection is made. This can be done by making the return member form part of the test circuit (as shown in Figure 9), or by including an auxiliary member which is connected to the end of the source member which is remote from the second point. If such a component is present, the sensitivity of the system will be the same throughout its length. In the absence of such a component, the impedance of the locating member (between the first and second points) will also be a variable, and it will not be possible to fix precisely the range of impedances of the connection which will cause an event to be signalled. When no such component is present, the limiting value or values of the impedance of the connection should preferably be at least 2 times, particularly at least 5 times, especially at least 10 times, the impedance of the full length of the locating member.

The sensitivity of such systems can easily be changed (for example so that leaks of different minimum sizes are signalled). When using a fixed current source, sensitivity can be changed by changing the compliance voltage of the source and/or by including a known impedance in the test circuit, and/or by changing the preselected range of output voltages.   When using
a fixed voltage source, the size of the voltage can be
changed, and/or a known impedance can be included in
the test circuit, and/or the preselected current value
can be changed.

The invention includes apparatus which is suitable
for connection to locating, source and return members
in order to provide a system in which information is
reported only when V/I is within a predetermined range,
the apparatus comprising

    (1)  a first terminal;

    (2)  a second terminal;

    (3) a third terminal;

    (4)  means for connecting the first and second
         terminals to a power source;

    (5)  a voltage-measuring device for measuring the
         voltage drop between the second and third
         terminals;

    (6)  a display unit for displaying information
         derived from a voltage drop measured by the
         voltage-measuring device; and

    (7)  a device which, when the first and second
         terminals are connected to a power source and
         are connected to each other through a locating
         member and a source member, thus forming
         a test circuit, prevents the display unit from
         displaying information if the value of the
         ratio V/I is outside a predetermined range,
         where I is the current in the test circuit in
         amps and V is the output voltage of the power
         source in volts.

This apparatus will often comprise a support member to which components (1) to (7) are attached, and/or a housing which provides physical and/or electrical protection for the components.

(5) MEASURING THE VOLTAGE DROP DOWN THE LOCATING
    MEMBER WITH THE AID OF A REFERENCE IMPEDANCE

When a "fixed" current source is used to provide a very low current, the current may vary substantially (e.g. by about 4%) from the "fixed" value (even when the output voltage is less than the compliance voltage). Other factors may also cause the current in the test circuit to vary with time. Under these circumstances, preferably the test circuit includes a reference impedance which is connected in series with the locating member, and the location of the first point is calculated from the ratio of the voltage drop between the first and second points to the voltage drop over the reference impedance. In effect, this procedure measures the current in the test circuit by measuring the voltage drop over the reference impedance. For further details, reference should be made to the United States Patent Application Serial No. 603,484, filed by Bonomi and Frank on April 24, 1984 (MPO932-US1).

(6) THE LOCATING MEMBER

The locating member is preferably an elongate member, this term being used to denote a member having a length which is substantially greater, e.g. at least 100 times greater, often at least 1,000 times greater, sometimes at least 10,000 times greater or even at least 100,000 times greater, than either of its other dimensions.

However, the locating member can also be in the form of a sheet or some other more complex shape.

The locating member preferably has sufficient impedance to cause a voltage drop which is easily and accurately measured. Preferably, therefore, it has a resistance which averages at least 0.1 ohm/ft (0.33 ohm/m), particularly at least 1 ohm/ft (3.3 ohm/m), e.g. 1 to 5 ohm/foot (3.3 to 16.5 ohm/m). On the other hand, its resistance should preferably not be too high and is preferably averages less than $10^4$ ohm/foot $(3.3 \times 10^4$ ohm/m), particularly less than $10^2$ ohm/foot $(3.3 \times 10^2$ ohm/m), especially less than 20 ohm/foot (65.5 ohm/m). A key feature of the present invention is that, under the conditions of operation, the impedance of the locating member is dependent substantially only on the distance between the first and second points. This is essential because it is not otherwise possible to calculate the location of the first point from the change in voltage measured by the voltage-measuring device. The locating member may be of constant cross-section along its length so that its resistance per unit length is constant and the voltage change is directly proportional to the distance between the first and second points. However, this is not essential, providing that the impedance changes in a known fashion along the length of the member, so that the voltage change and the distance can be correlated. Thus under some circumstances, considerable advantages may result from the use of a locating member which comprises a plurality of spaced-apart impedances which are connected by intermediate elongate components of low impedance, as described in the application filed in the United States by Paul Hauptly on _____, 1984 (MP0920-US1). The most common variable affecting the resistivity (and, therefore, resistance) of the locating member is temperature. Many materials, and in particular copper and other metals most commonly used for electrical conductors, have a resistivity which changes with temperature to an extent which, although unimportant for many purposes, can result in unacceptable margins of error in locating the first point under conditions in which the temperature can vary substantially and unpredictably along the length of the locating member. It is preferred, therefore, that the locating member should have a temperature coefficient of impedance (usually resistance) which averages less than 0.003, particularly less than 0.0003, especially less than 0.00003, per degree Centigrade over at least one 25° temperature range between -100°C and +500°C, and preferably over the temperature range 0° to 100°C, especially over the temperature range 0° to 200°C. For a simple metal conductor, the temperature coefficient of impedance is the same as the temperature coefficient of resistivity. The value for copper is about 0.007 per deg C. Metals having lower temperature coefficients of resistivity are well known and include Constantan (also known as Eureka), Manganin and Copel, and others listed for example in the International Critical Tables, published 1929 by McGraw-Hill Book Co., Vol. VI, pages 156-170.

It is of course important that the locating, source and return members should be sufficiently strong, and should be assembled in such a way, that they can withstand the stresses on them during installation and use. For the return member this usually presents no problem, because it can be and preferably is securely enclosed in a conventional polymeric insulating jacket. However, electrical contact is necessary at intermediate points of the locating and source members, and can be necessary at intermediate points of the return member also. This can result in problems, particularly when one or more of the members is a wire of relatively small cross-section. However, we have found that in many applications of the invention, especially those in which the event is the presence of an electrolyte, an excellent combination of desired properties can be obtained through the use of a locating member and/or a member comprising a metal core and an elongate jacket which electrically surrounds the core and which is composed of a conductive polymer. The term "electrically surrounds" is used herein to mean that all electrical paths to the core (intermediate the ends thereof) pass through the jacket. Normally the conductive polymer will completely surround the core, being applied for example by a melt-extrusion process; however it is also possible to make use of a jacket which has alternate insulating sections and conductive sections.

The term "conductive polymer" is used herein to denote a composition which comprises a polymeric component (e.g. a thermoplastic or an elastomer or a mixture of two or more such polymers) and, dispersed in the polymeric component, a particulate conductive filler (e.g. carbon black, graphite, a metal powder or two or more of these). Conductive polymers are well known and are described, together with a variety of uses for them, in for example U.S. Patents Nos.

2,952,761, 2,978,665, 3,243,753, 3,351,882, 3,571,777, 3,757,086, 3,793,716, 3,823,217, 3,858,144, 3,861,029, 4,017,715, 4,072,848, 4,117,312, 4,177,446, 4,188,276, 4,237,441, 4,242,573, 4,246,468, 4,250,400, 4,255,698, 4,271,350, 4,272,471, 4,304,987, 4,309,596, 4,309,597, 4,314,230, 4,315,237, 4,317,027, 4,318,881 and 4,330,704; J. Applied Polymer Science 19 813-815 (1975), Klason and Kubat; Polymer Engineering and Science 18, 649-653 (1978), Narkis et al; German OLS 2,634,999; 2,755,077; 2,746,602; 2,755,076; 2,821,799; European Application No. 38,718; 38,715, 38,718, 38,713, 38,714, 38,716; U.K. Application No. 2,076,106A; and the applications corresponding to U.S. Serial Nos. 184,647 (Lutz), 250,491 (Jacobs et al) 273,525 (Walty), 274,010 (Walty et al), 272,854 (Stewart et al), 300,709 (van Konynenburg et al), 369,309 (Midgley et al), and 380,400 (Kamath).

The resistivity of conductive polymers usually changes with temperature at a rate well above the preferred temperature coefficient of resistivity set out above, and the PTC conductive polymers often increase in resistivity by a factor of 10 or more over a 100°C range. Accordingly it is important that in a locating member comprising a conductive polymer jacket, at all temperatures likely to be encountered, e.g. at all temperatures from 0° to 100°C, each longitudinal section of the conductive polymer jacket has a resistance which is at least 100 times, preferably at least 1000 times, the resistance of the core of that longitudinal section. In this way (since the core and the jacket are connected in parallel), the jacket does not make any substantial contribution to the resistance of the elongate conductor, and any change in its resistance with temperature is unimportant.

The second point on the locating member must have a known location, and it is normally a fixed point. When the system is designed to detect different types of events occurring independently, the second point is preferably the same fixed point for detection of the different events. In the case of an elongate locating member, the second point will normally be at one end or the other of the locating member. However, the invention includes, for example, the simultaneous or sequential use of a plurality of second points to determine the locations of a plurality of first points when a number of different events having identified a number of first points.

(7)  THE SOURCE MEMBER

The source member preferably has the same general configuration and follows the same general path as the locating member. Thus it is preferred that the locating and source members are elongate members which follow the same elongate path, often (but by no means necessarily) parallel to each other. If the adjacent ends of the source and locating members are connected to each other (through the power source), then a wide variety of elongate electrical connection members will provide the necessary connection to the event-sensitive connection means and,where appropriate, also provide the event-sensitive connection means. Thus the source member can be the same as, or different from, the locating member. Especially when the locating member is a wire electrically surrounded by a conductive polymer jacket, the source member is preferably a wire electrically surrounded by a conductive polymer jacket. The disclosure in Section 6 above about conductive polymers is also applicable to the source member. The source member preferably has substantially no reactance. In order to reduce the input voltage required to provide a controlled current in the test circuit, the source member can have a lower resistance per unit length than the locating member.

When the source and locating members are connected so as to provide a test circuit in which the only variable impedance is the connection between the source and locating members caused by the event, then the source member is preferably substantially identical to the locating member.

(8)  THE RETURN MEMB

In many cases, the return member also has the same general configuration and follows the same general path as the locating member. This is preferred when the return member is electrically connected to the locating member at the ends thereof but is otherwise insulated therefrom. On the other hand it is not necessary when the locating and source members follow a path in the form of a loop, since the return member can then be a relatively short member which joins (via the voltage-measuring device) the two ends of the locating member. The return member will usually follow the same general path as the source and locating members in another embodiment in which, when an event occurs, not only is a connection made between the locating and source members, but also an electrical connection of known resistance is made between the return member and the locating member at the first point or at some other point on the locating member which is further away from the second point. The return member preferably has substantially no reactance and can conveniently be a simple insulated wire whose resistance per unit length is sufficiently low for the resistance of the return member to be ignored in obtaining the desired information about the event, e.g. less than 0.01 times the resistance per unit length of the locating member.

(9)  ASSEMBLY OF THE ELONGATE CONNECTION MEMBERS

The source and locating members, usually the return member, the auxiliary member when present, and any other elongate members which may be desired (e.g. for checking continuity or to provide physical strength) can be combined together in any convenient way to provide a cable which can be positioned along the desired elongate path. If desired the return member, or the locating member, or a further member, can be relatively large and strong, and thus be a strength member to which the other members are secured, e.g. by wrapping, preferably in the form of a braid which may include additional elongate members. For a more detailed description of various wrapped configurations, reference should be made to U.S. Patent Applications Nos. 556,740 and 556,829 (MPO892) filed by Robert Wasley.

(10) USE OF SUBSTANTIALLY IDENTICAL LOCATING AND SOURCE MEMBERS

Very valuable improvements can be obtained through the use of a locating member which has impedance characteristics such that, and which is connected so that, the only variable impedance in the test circuit is the impedance of the connection which is created by the occurrence of the event. As noted above, this makes it possible to design a system which, at all points along its length, will be sensitive only to events which create a connection whose impedance is within a predetermined range. Another important advantage is that the impedance of the connection itself can be measured. This can be done, for example,

    (a)   when a constant current source is used, by measuring the output voltage;

    (b)   when a constant voltage source is used, by measuring the current in the test circuit; or

    (c)   by including a switching arrangement so that, after the location of the event has been determined, a new circuit is created in which the voltage measured by the voltmeter is a measure of the impedance of the event.

When the locating member is of the kind described in the Hauptly application (MPO920-US1), in which the locating member includes a plurality of spaced-apart impedant components, the source member preferably comprises corresponding spaced-apart impedant components. In order to make up such a system it is convenient to use pre-assembled modules which can be connected into the locating and source members to provide impedant components in those members and an event-sensitive connection member to connect those members when an event takes place. Such modules are novel and form part of the present invention. Thus in a further

0253085
MPO869

aspect the invention provides an event-sensitive module which is suitable for use in a method for detecting and obtaining information about an event, and which comprises

(1) a first impedant component having substantial impedance;

(2) a first conductor which has a relatively very small impedance and one end of which is connected to the first impedant component;

(3) a second impedant component having the same impedance as the first impedant component;

(4) a second conductor which has a relatively very small impedance and one end of which is connected to the second impedant component;

the first impedant component and the first conductor, in the absence of an event, being electrically insulated from the second conductor and the second impedant component; and

(5) an event-sensitive connection means which, upon occurrence of an event, can effect electrical connection between the first and second conductors;

the first impedant component and the first conductor being connectable in series with incoming and outgoing portions of an elongate electrically conductive locating member, and the second impedant component and the second conductor being connectable in series with incoming and outgoing portions of an elongate electrically conductive source member. Preferably the module also comprises a third impedant component connected to the other end of the first conductor, and a fourth impedant component connected to the other end of the second conductor, the third and fourth components having the same impedance as the first and second components. When using such a preferred module it does not matter whether the incoming portion of the locating member is connected to the first component and the outgoing portion of the locating member is connected to the third component, or vice versa. Similarly it does not matter whether the incoming portion of the source member is connected to the second component and the outgoing portion of the source member is connected to the fourth component, or vice versa. This reduces the danger of incorrect installation of the system. Indeed, if the event-sensitive connection means operates in the same way whichever the direction of the current through it, it does not matter how the intermediate portions of the source and locating members are connected to the module, provided that the locating member is connected through one of the conductors and the source member is connected through the other conductor.

The module will often comprise a support member to which components (1) to (5) are secured; and/or a housing which provides physical and/or electrical protection for the components; and/or terminals for connecting the module as indicated above.

(11) <u>THE POWER SUPPLY</u>

The current which is transmitted between the first and second points must be of known size, and is preferably supplied by a controlled current source, e.g. a galvanostat; however, a controlled voltage source can be used providing that a current-measuring device is included in the apparatus so that the location of the first point can be calculated. The current may be a continuous or pulsed direct current or an alternating current of regular sinusoidal or other form. The current which flows between the first and second points is often in the range of 0.05 to 100 milliamps, particularly 0.1 to 10 milliamps, e.g. 0.5 to 3 milliamps. However, where very long paths are to be monitored for events, even lower currents can be employed, especially when using a reference impedance, as described by Boomi and Frank in MPO832-US1). The controlled current source is preferably a fixed current source or a current source which can be adjusted to provide current of a desired and known value, for example to obtain improved accuracy in locating a fault which was detected at a lower current level. However, it is also possible to use a fixed voltage source, in combination with a current-measuring device which measures the current flowing between the first and second points. The power source is preferably connected to the locating member at the second point at all times and, in the absence of an event, is otherwise insulated from the locating member.

(12) THE VOLTAGE-MEASURING DEVICE

The voltage-measuring device can be of any kind, and suitable devices are well known to those skilled in the art. Preferably the voltage-measuring device is a voltmeter which has a resistance of at least 10,000 ohms, preferably at least 1 megohm, especially at least 10 megohms.

(13) PHYSICAL AND ELECTRICAL RELATIONSHIPS BETWEEN THE
    COMPONENTS OF THE APPARATUS

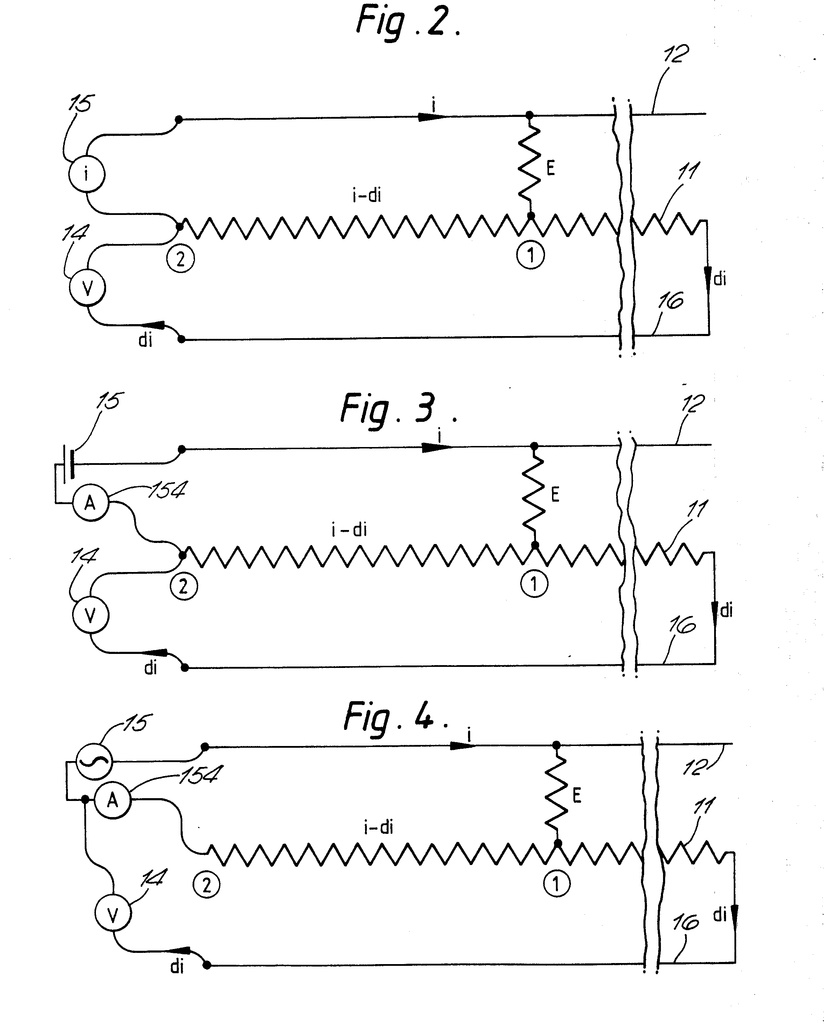

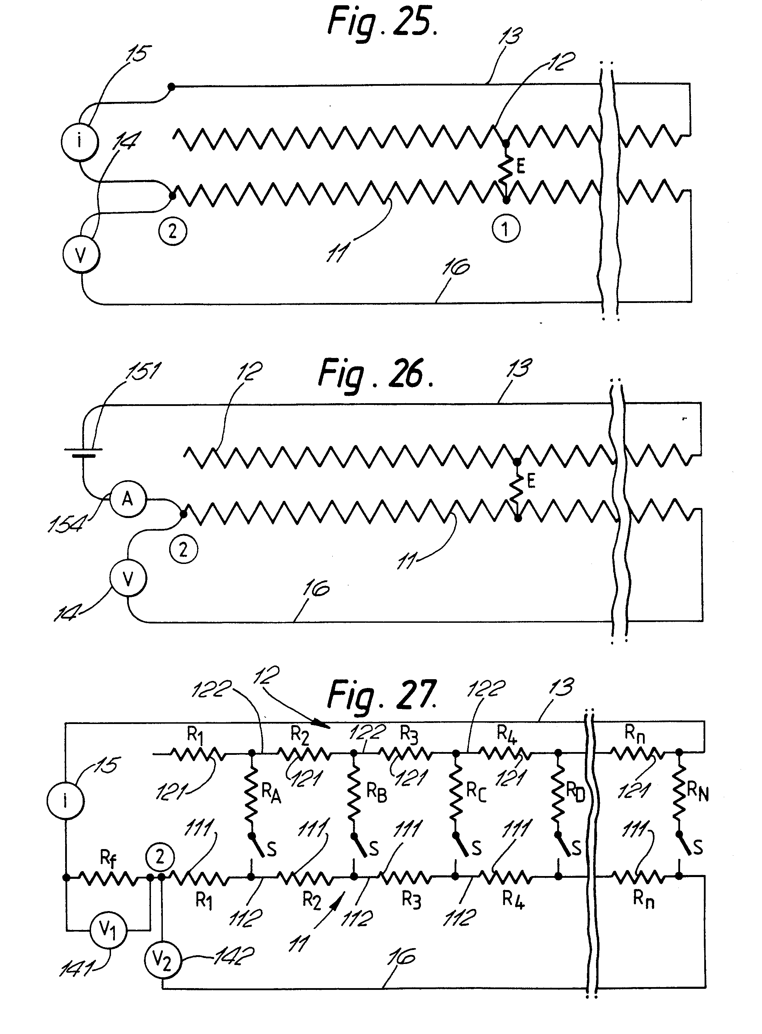

As briefly indicated in the description of Figure 1, the physical and electrical relationships between the components of the apparatus of the invention can be widely varied. Figures 2-24 show a number of different arrangements which are specific examples of the circuit generically illustrated in Figure 1 and of various preferred embodiments of the invention. In each of Figures 2-24, there is a power source 15, a voltage-measuring device 14, a locating member 11, a source member 12 and a return member 16. The locating member is shown as a resistor because it must have appreciable resistance in order for the voltage drop down it to be large enough to permit accurate location of the point 1, at which the source member is connected to the locating member. The source member is shown as a simple low resistance conductor in some Figures and as a resistive member identical to the locating member in other Figures. The return member is shown as a simple low resistance conductor, which it preferably is, but the return member can have substantial resistance, providing that it is a known resistance. The connections E, $E_1$, $E_2$ and $E_3$, are shown as resistors if they form part of the test circuit, since the invention permits these connections to be of indeterminate and high resistance (though of course they can be of substantially zero resistance or of substantial and known resistance). On the other hand, these connections are shown as simple conductors if they form part of the reference circuit, since the invention requires that these connections are of known, and preferably small, resistance. In a number of the Figures, there are shown switches, S, $S_1$ and $S_2$. Any other means can be employed, in addition to simple switches making a zero resistance electronic contact, in the test circuit, and any other means providing a connection of known resistance can be used in the reference circuit. In most of Figures 2-29, the power source is shown as a controlled current source, but in Figures 3 and 26, the power source is a battery and the test circuit includes an ammeter 154; and in Figure 4 the power source is a controlled voltage AC source and the test circuit again includes an ammeter 154.

Some of the different possible relationships between the components will now be enumerated, using Figures 2-29 as examples of these relationships.

(A) The power source can be positioned near the second point on the locating member, as illustrated in Figures 2-7 and 12-29, or near the end of the locating member which is remote from the second point, as illustrated in Figures 8-9. In most cases, the power source and the voltage-measuring device are positioned near to each other as illustrated in Figures 2-5 and 7-29.

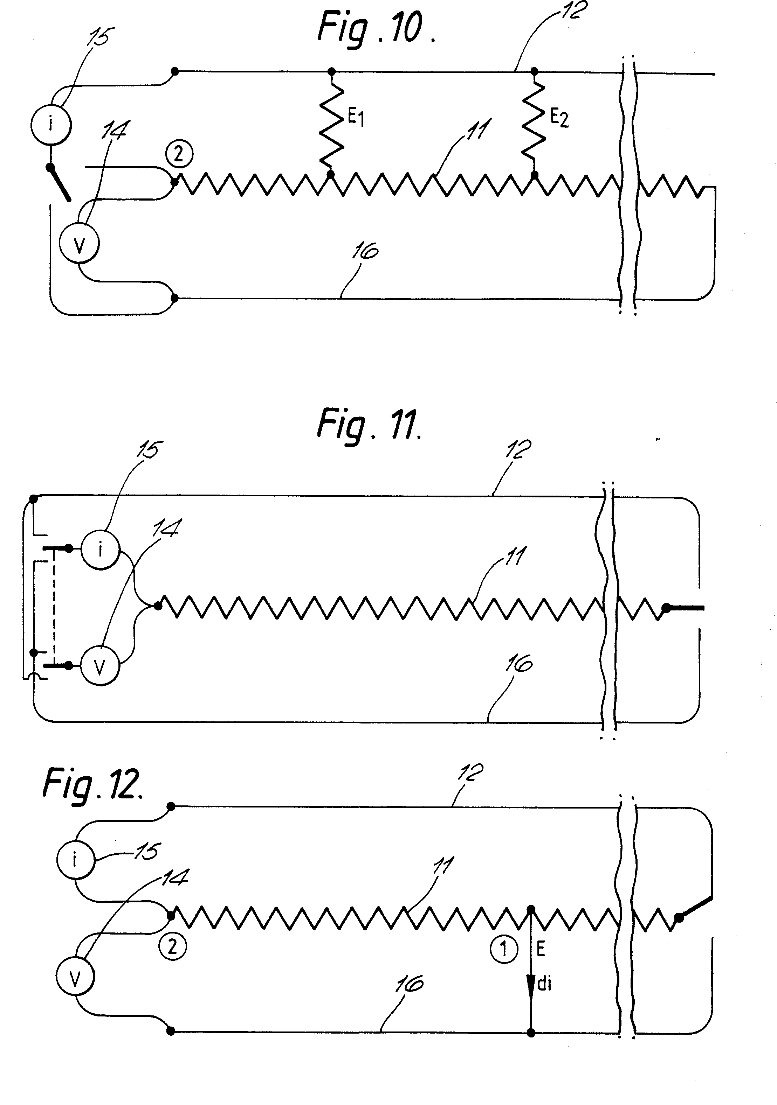

(B)  As shown for example in Figure 10, the apparatus can include one or more switches, which may be ganged together or may operate independently, to provide for switching the connections between the locating member and the power source from a first arrangement in which the second point is at one end of the locating member as shown in Figure 2, to a second arrangement in which the second point is at the opposite end of the locating member, as shown in Figure 9, thus making it possible first to measure the distance from one end that an event has taken place and then to measure the distance from the other end that an event has taken place.

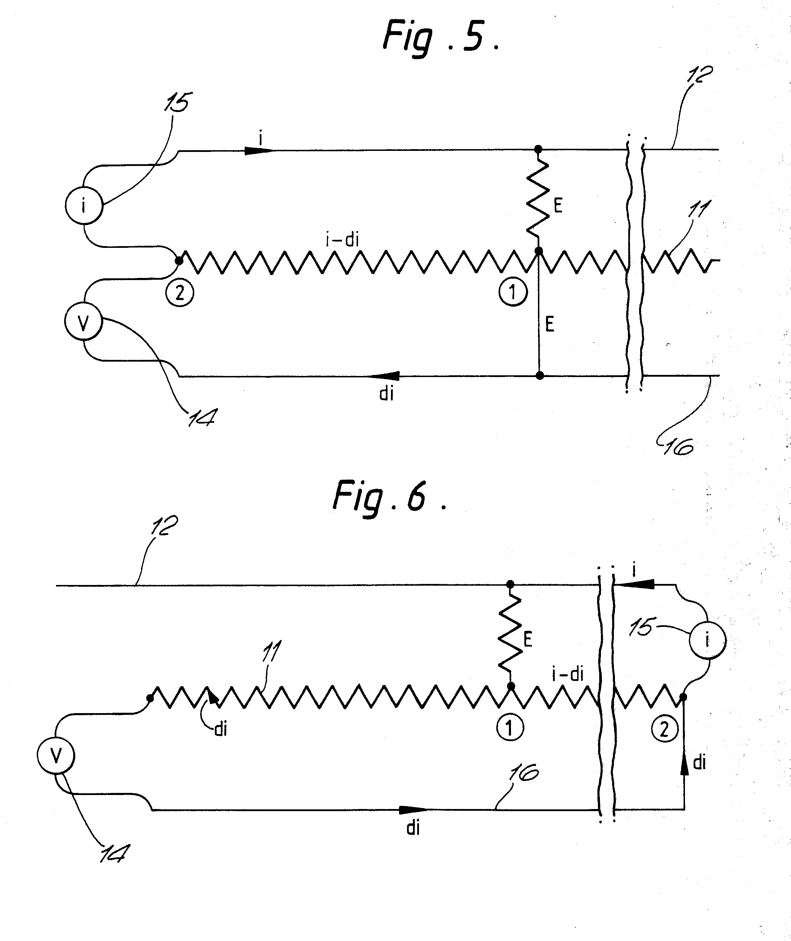

(C)  It is also possible for the apparatus to be one in which occurrence of the event causes not only connection between the source and locating members, but also connection between the return and locating members, as shown for example in Figures 5, 7, 19 and 20.  Such a system can be  valuable for example in providing a cut-to-length apparatus.  The making of the connection between the locating and return members can be the direct result of the making of the connection between the locating and source members, e.g. by means of a ganged switch, or the condition which causes one connection to be made can also cause the other connection to be made.  These two possibilities are shown in Figure 5.  Alternatively, the connection between the locating and return members can result from the existence of a condition which is different from the condition which effects connection between the locating and source members.  This possibility is shown in Figures 7, 19 and 20.

(D)  It is also possible, as shown for example in Figure 11, for the apparatus to include one or more switches, which may be ganged together or may operate separately, so that the apparatus can be converted into an electrical system as illustrated in Figure 12, in which

  (a)  an electrical current is driven down the whole length of the locating member by the power source,

  (b)  the return member is electrically connected to the second point on the locating member through the voltage-measuring device, and is otherwise insulated from the locating member, and

  (c)  when a second and different type of event occurs, a connection of known impedance is made between the locating member and the return member, thus creating a reference circuit which comprises a voltage- measuring device, those parts of the locating member and return member which lie between the first and second points, and the connection of known impedance, the voltage-measuring device having a known impedance which is very high by comparison with any unknown part of the impedance of the other components of the reference circuit.

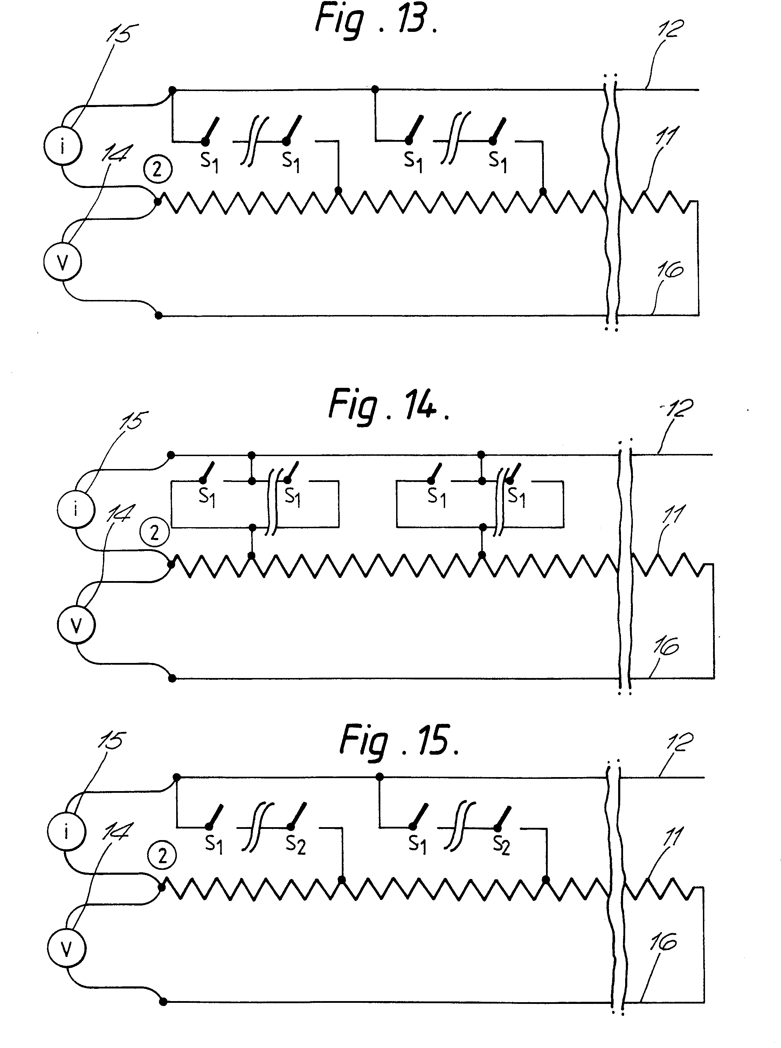

(E)  As shown for example in Figure 13, the event can comprise the existence of a particular condition at each of a plurality of spaced-apart locations, the connection between the locating member and the source member being made through an event-sensitive connection member comprising a plurality of condition-sensitive members which are electrically connected in series, which are respectively located at each of said spaced-apart locations, and each of which is electrically conductive when said condition exists at its location and is not electrically conductive when said condition does not exist at its location.

(F) As shown for example in Figure 14, the event can comprise the existence of a particular condition at at least one of a plurality of spaced-apart locations, the connection between the locating member and the source member being made through an event-sensitive connection member comprising a plurality of condition-sensitive members which are electrically connected in parallel, which are respectively located at each of said spaced-apart locations, and each of which is electrically conductive when said condition exists at its location and is not electrically conductive when said condition does not exist at its location.

(G) As shown for example in Figure 15, the event can comprise the existence of a first condition at a first location and the existence of a second condition at a second location (which may be immediately adjacent the first location), the connection between the locating member and the source member being made through an event-sensitive member comprising (a) a first-condition-sensitive member which is at the first location and which is electrically conductive when the first condition exists at the first location and is not electrically conductive when the first condition does not exist at the first location and (b) a second-condition-sensitive member which is at the second location, which is electrically conductive when the second condition exists at the second location and is not electrically conductive when the second condition does not exist at the second location, and which is electrically connected in series with the first-condition-sensitive member.

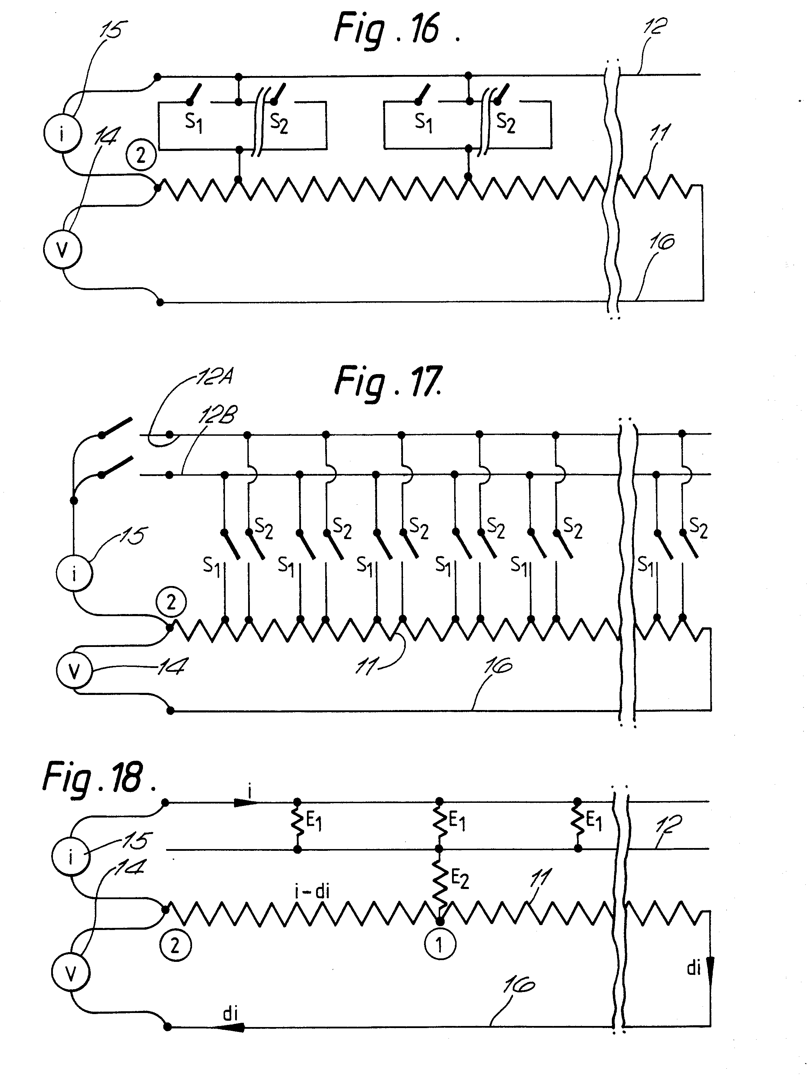

(H)  As shown for example in Figure 16, the event can comprise the existence of a first condition at a first location or the existence of a second condition at a second location, (which may be immediately adjacent the first location), the connection between the locating member and the source member being made through an event-sensitive member comprising (a) a first-condition-sensitive member which is at the first location and which is electrically conductive when the first condition exists at the first location and is not electrically conductive when the first condition does not exist at the first location and (b) a second-condition-sensitive member which is at the second location, which is electrically conductive when the second condition exists at the second location and is not electrically conductive when the second condition does not exist at the second location, and which is electrically connected in parallel with the first-condition-sensitive member.

(I)  It is also possible, as shown for example in Figure 17, for the system to include two or more source members, which become respectively connected to the locating member when a particular condition (different for each source member) exists.  In this case the event is the existence of one of those two (or more) conditions at any point along the elongate path followed by the locating and source members. The system can also include switches, e.g. as shown in Figure 17, such that it is possible to disconnect all but one of the source members, and thus to determine which of the particular conditions exists.

(J)  It is also possible, as shown for example in Figure 18, for the system to include at least one auxiliary source member which is connected to the power source and which becomes connected to the source member (or to another auxiliary source member) when a particular second condition exists, the second condition being different from the first condition which causes the source member to become connected to the locating member. In this case, the event is the existence, at any one or more points along the path, of a second condition which causes the auxiliary source member to become connected to the source member, and the existence, at one or more points along the path, of a first condition which causes the source and locating members to become connected.

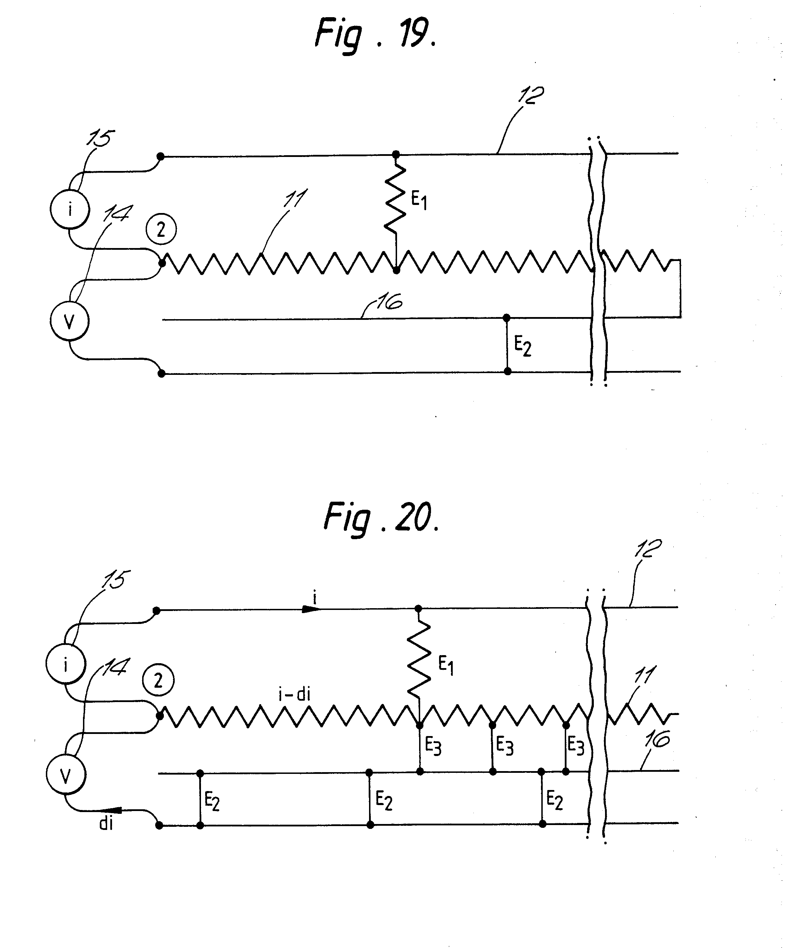

(K)  It is also possible, as shown for example in Figures 19 and 20, for the system to include at least one auxiliary return member which is connected to the voltage-measuring device and which becomes connected to the return member when a second condition exists, the second condition being different from the first condition which causes the source and locating members to become connected. The return member can be connected to the end of the locating member which is remote from the second point, as illustrated in Figure 19, in which case the event is the existence of the first condition at one or more points along the path and the existence of the second condition at one or more points along the path, with the information provided being the location of the first condition which is nearest to the second point. Alternatively, as illustrated in Figure 20, the return member can become connected to the locating member as the result of a third condition.

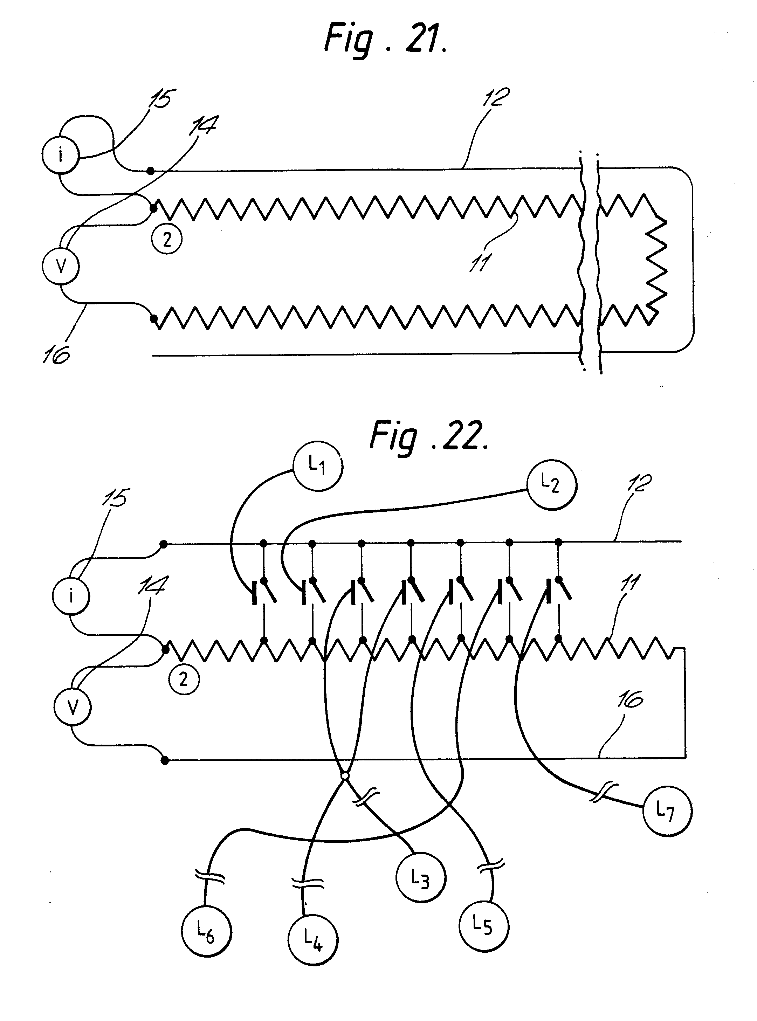

(L) It is also possible, as shown for example in Figure 21, for the apparatus to follow an elongate path in the form of a loop, so that the return member need not follow the elongate path but can simply join, via the voltage-measuring device, the two ends of the locating member.

(M) It is also possible, as shown for example in Figure 22, for a plurality of event-detecting stations (which can detect the same or different events) to be positioned at locations which are remote from the locating member and to be electrically (or otherwise) connected to switches (e.g. electromagnetically operated relays) between the locating and source members.

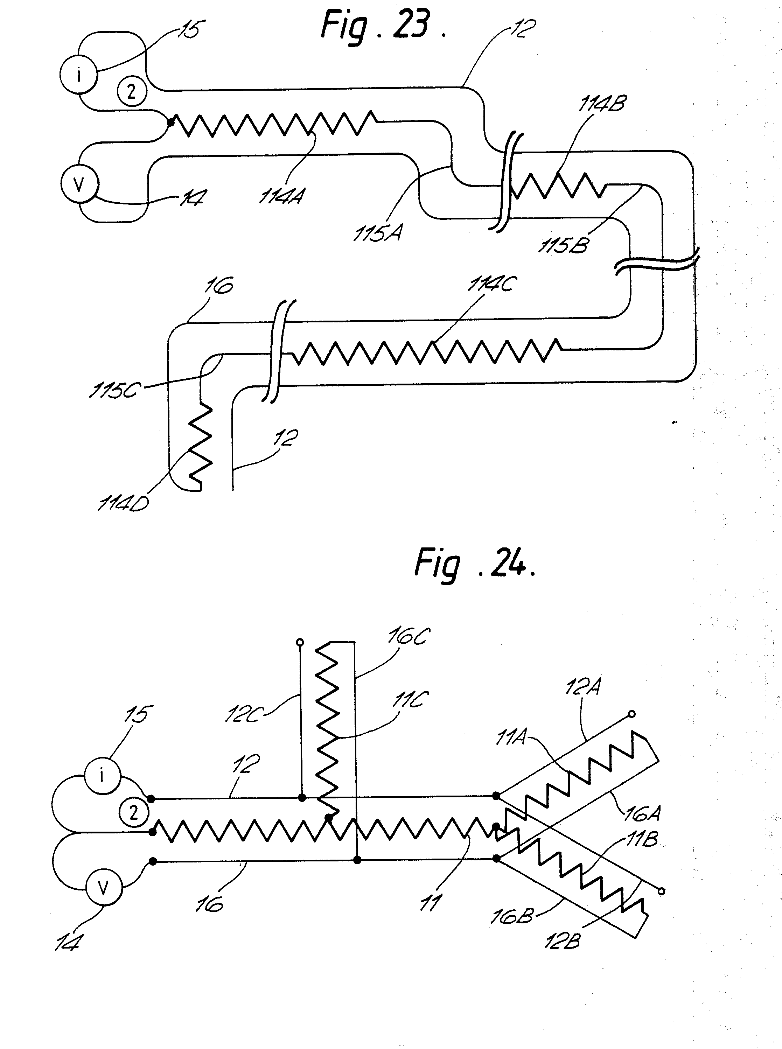

(N) It is also possible, as shown for example in Figure 23, when event-detection is required only in spaced-apart zones, for the locating member to comprise (a) a plurality of spaced-apart elongate locating components (114A, 114B, 114C and 114D in Fig. 23), each of which provides a series of points to which the connection can be made and preferably has a relatively high resistance per unit length, and (b) a plurality of spaced-apart elongate intermediate components (115A, 115B, and 115C in Figure 23) which physically separate and electrically connect the locating components, which cannot become directly connected to the source member
and which preferably have a relatively low resistance.
This system might be used for example when detection
and location was needed within each of a plurality of
houses separated from each other along a street, but
not between the houses.

(O)  The method can also be used to locate events along
a branched path, as illustrated in Figure 24.  However,
when using such a branched system, if the voltage-
measuring device shows an event at a distance beyond
the first branching point, then there are often two or
more possible locations for the fault.  If desired, the
location can be precisely identified by connecting the
controlled current source and voltmeter to the conductors
at the branch point(s) (preferably _via_ low resistance
drop leads installed at the same time as the detection
system).  (This expedient can also be used in unbranched
systems in order to provide improved accuracy of location
of the event, after the general vicinity of the event
has been indicated.)  Alternatively, AC current sources
of different frequencies can be employed sequentially
and filters can be placed in the different branches so
that only one branch is being tested at any one time.
of the event, after the general vicinity of the event
has been indicated.)  Alternatively, AC current sources
of different frequencies can be employed sequentially
and filters can be placed in the different branches so
that only one branch is being tested at any one time.

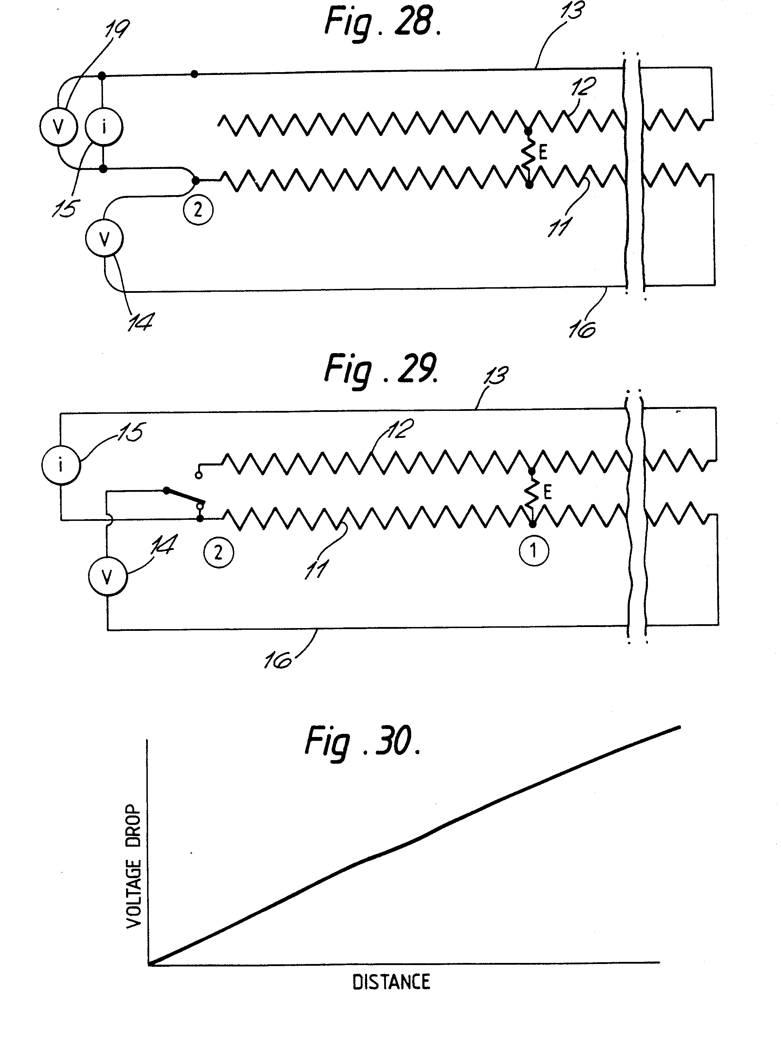

(P)  It is also possible, as shown for example in
Figures 9 and 25-29, for the source member to have the
same impedance characteristics as the locating member,
and to be connected so that the only variable impedance in the test circuit is the impedance of the connection, Figures 9, 25, 26, 28 and 29 show the locating and source members as continuous resistors of constant resistance per unit length.  Figure 27 shows the locating and source members comprising a plurality of resistors 111 (in the locating member) and 121 (in the source member), which can have the same or different resistances $R_1$ to $R_m$, and a plurality of low resistance intermediate components 112 and 122.  The event connections E in Figures 25, 26, 28 and 29 are shown as resistors of indeterminate size.  In Figure 27, the event connection is made by closing one or more of the switches S, which have in series with them resistors $R_A$ to $R_N$ which can be the same or different.

Figure 27 also shows a reference resistor $R_f$ connected in series with the locating member, and a voltmeter 141 which measures the voltage drop over the reference resistor, so that the location of the connection can be calculated from the ratio of the voltage drops measured by the two voltmeters.

Figure 28 is the same as Figure 25 except that it also includes a second voltmeter 19 whch measures the output voltage of the power source.  The impedance of the connection E can be calculated from the output voltage (so long as the power source is delivering the desired "fixed" current).

Figure 29 is somewhat similar to Figure 25, but incorporates a switch 161 such that the return member can be connected as shown (the system then being precisely as shown in Figure 25) or can be disconnected from the near end of the located member and connected to the near end of the source member. In the latter configuration, the voltage measured by the voltmeter is a measure of the impedance of the connection E.

## (14) VOLTAGE DROP VS. DISTANCE

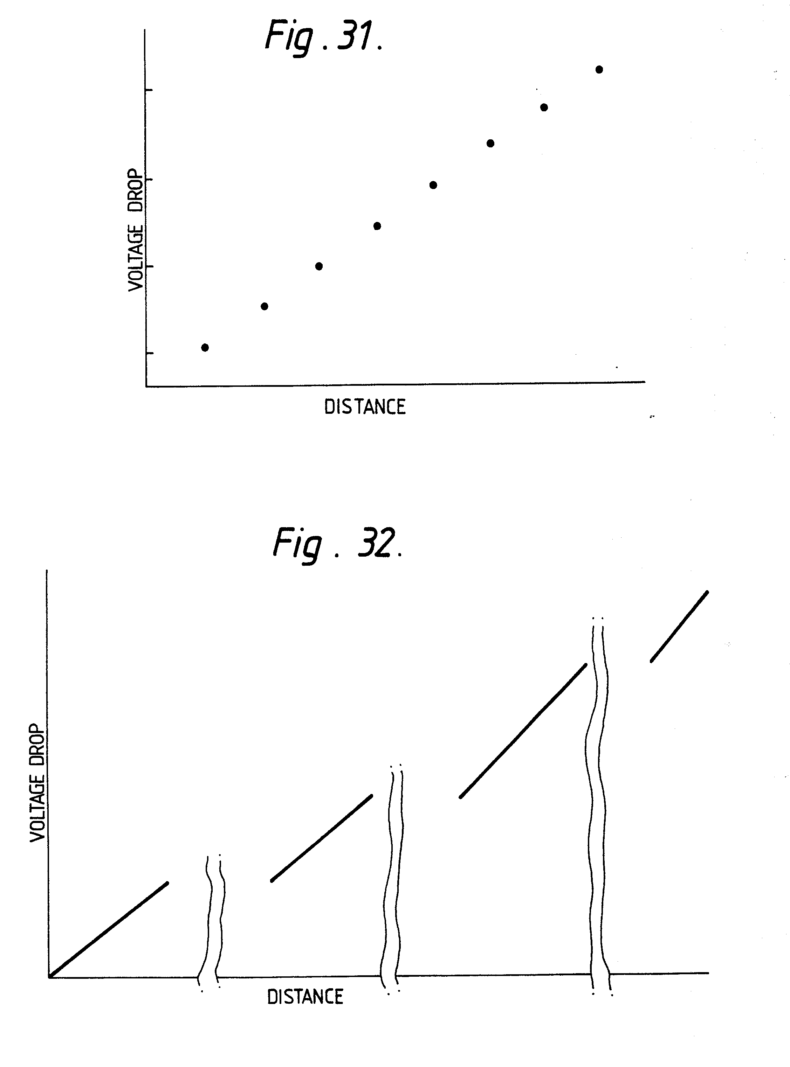

The relationship between the voltage drop measured by the voltage-measuring device and the distance between the first and second points will depend on the way in which the apparatus is designed. When connection can be made to the locating member at any point along its length, and the locating member is of uniform impedance along its length, then the relationship will be a straight line of uniform slope, as illustrated in Figure 30. When the event-sensitive connection means is discontinuous, so that connection to the locating member is possible only at spaced-apart points, then the relationship will be a series of points as shown in Figure 31. When the locating member is divided into locating and connection zones and can be contacted at any point within a locating zone, as shown in Figure 23, then the relationship is as shown in Figure 32.

## (15) PARTICULAR EVENT-SENSITIVE CONNECTION MEANS

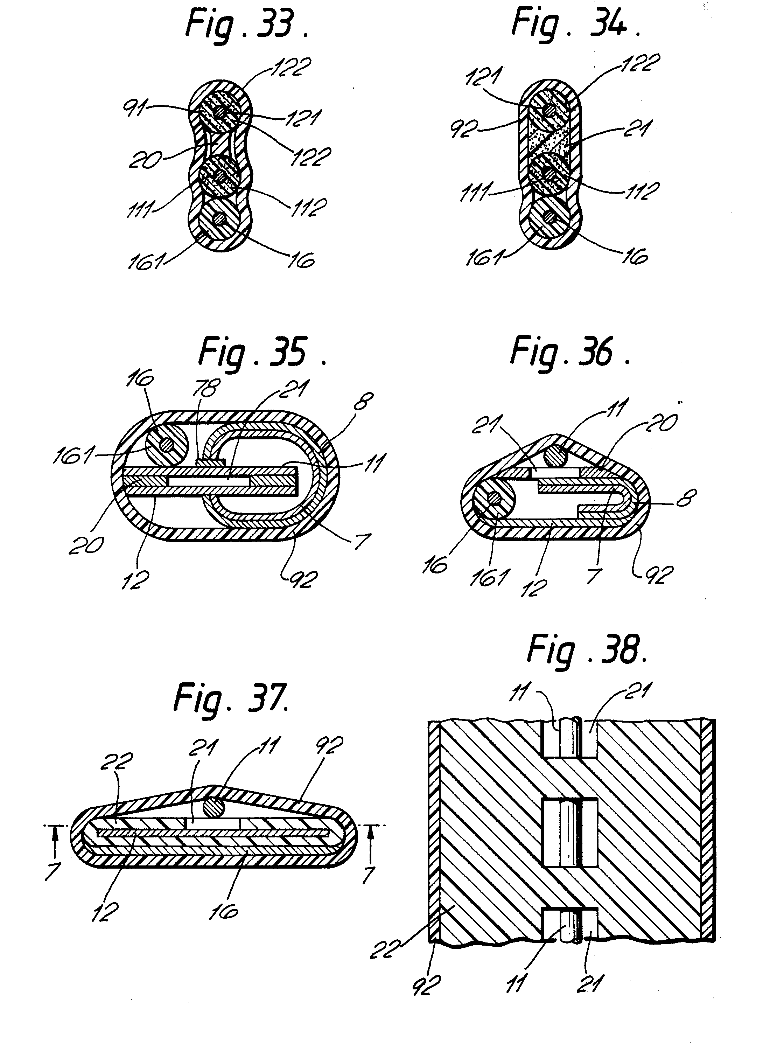

Figures 33-38 show cross-sections through apparatus of the invention. In Figures 33 and 34, the apparatus includes a source member having a metal core 121 and a conductive polymer coating 122; a locating member having a core 111 which is composed of a metal whose resistivity is substantially invariant with temperature and a conductive polymer coating 112; and a return member 16 which is composed of metal and is surrounded by a polymeric insulating jacket 161.

In Figure 33, a polymeric insulating connecting member 20 having concave surfaces lies between the source and locating members, and the components are joined together by an apertured, and therefore liquid-permeable, insulating jacket 91. So long as there is no electrolyte around the apparatus shown in Figure 33, there is no electrical connection between the locating and source members. However, if the apparatus is exposed to an electrolyte, an ionic connection is made between the locating and source members.

In Figure 34, a member 21 lies between the locating and source members, and the components are surrounded by an insulating jacket 92. Under normal conditions, the member 21 prevents electrical contact between the locating and source members, but the member 21 consists of or contains a material which becomes an electrical conductor when an event occurs. For example, the member 21 can comprise an organic polymer foam which is impregnated with a material which forms mobile ionic species when the foam structure is damaged, for example by an event involving excessive pressure transmitted through a flexible jacket 92, or an event involving excessive temperature which causes the foam to melt, or an event involving the presence of a chemical which can penetrate the jacket 92 (which may be apertured for this purpose) and which reacts with the foamed member. The member 21 can also be composed of a material which becomes conductive when it is compressed.

Figure 35 is a cross-section through apparatus for detecting an over-temperature fault condition.

Locating member 11 and source member 12 are metal strips spaced apart by insulating strips 20, defining an air gap 21 between the conductors. Return member 16 and insulating jacket 161 surrounding it are also present. A bimetallic C-clip comprising metal strips 7 and 8 bears on the center portions of the strips 11 and 12 through insulating pad 78; under normal conditions the clip is in the open position shown, but it is so constructed and arranged that if the temperature exceeds a particular value, the clip closes and brings the strips 11 and 12 into electrical contact. Suitable C-clips can be composed of a spring steel member and a memory metal member. For example, if under normal conditions, the inner member 7 is composed of spring steel, and the outer member 8 is composed of a memory metal in the martensitic phase and is maintained in an expanded configuration by the member 7, then if the temperature reaches the transformation temperature of the memory metal, the member 8 will recover, overcoming the elastic resistance of the member 7 and bringing the strips 11 and 12 into contact.

Figure 36 is somewhat similar to Figure 35, but makes use of a bimetallic member to bring a strip 12 and a wire 11 into electrical contact if the temperature falls below a particular level. Strip 12 is connected to a C-clip having an inner member 7 composed of spring steel and outer member 8 composed of a memory metal. The C-clip is separated from wire 11 by an air gap 21 in an apertured insulating member 20. Under normal conditions, the memory metal member 8 is in the austenitic state and maintains the spring steel member 7 in a compressed configuration so that there is no contact between strip 12 and wire 11. If the temperature drops below the transformation temperature of the memory metal, thus converting the member 8 into the weak martensitic state, the spring steel member expands and effects electrical connection between the strip 12 and the wire 11.

In Figures 35 and 36, the C-member will generally comprise a plurality of discrete, spaced-apart, members. However, a continuous C-member will also be satisfactory.

Figures 37 and 38 show apparatus for detecting an increase in pressure, for example for placing under a floor covering as a burglar alarm. The source member 12 is in the form of a metal strip and is surrounded by an insulating polymeric sheet 22 which has apertures 21 in its top surface. The locating member 11 is a constant resistance metal wire which is separated from the member 12 by insulating sheet 22 and crosses over the apertures 21. The return member 16 is placed below the second conductor and is insulated therefrom at all points. A flexible insulating polymeric jacket 92 surrounds the various components. Under normal conditions the locating and source members are not electrically connected. However, if the pressure on the top surface of the insulating jacket increases sufficiently, the locating member is forced through aperture 21 to contact the source member.

The invention is illustrated by the following Examples:

## Example 1

A circuit as shown in Figure 2 was prepared. The controlled current source was a galvanostat with a compliance voltage of 18 volts and produced a controlled current of 0.001 amp. The voltmeter had an input impedance of 1 megohm and a full scale reading of 200 mV. The source member was a 30 AWG copper wire (diameter about 0.032 cm) which was surrounded by a melt-extruded jacket of a conductive polymer composition. The jacket was about 0.04 inch (0.1 cm) thick. The conductive polymer composition has a resistivity of about 3 ohm.cm at 25°C and comprised carbon black (about 45 parts by weight) dispersed in a thermoplastic rubber which is sold under the trade name TPR-5490 and which is believed to be a blend of polypropylene and an ethylene/propylene rubber (about 55 parts by weight). The locating member was the same as the first except that a 30 AWG Constantan wire (diameter about 0.032 cm) was used instead of the copper wire. The resistance of the second conductor was 2.940 ohms/foot (9.65 ohm/m). The return member was a 12 AWG copper wire (diameter about 0.28 cm) and it was surrounded by a polymeric insulating jacket.

In a number of tests, a damp sponge was placed on the locating and source members to effect electrical connection between them, the members being dried between the tests. It was found that, as expected from theory, the distance (d) in meters to the damp sponge could be calculated from the equation

$$d = \frac{V}{0.001 \times 9.65}$$

where V is the voltage (in volts) recorded by the voltmeter. The discrepancy between the actual and calculated values of d was less than 0.1%.

## Example 2

A circuit as shown in Figure 2 was prepared, using a galvanostat and voltmeter as specified in Example 1. An apparatus somewhat similar in operation to that shown in Figures 37 and 38 was prepared as follows. To provide the source member, a strip of copper foil was stuck to the interior bottom surface of a tube of cross-linked polyvinylidene fluoride. To provide the locating member, a 30 AWG Constantan wire (diameter about 0.0332 cm) was secured to the interior top surface of the polyvinylidene fluoride tube, diametrically opposite the copper strip, the wire being woven through the tube at intervals so that it was maintained substantially in contact with the tube throughout its length. The return member was a 30 AWG insulated copper wire (diameter about 0.032 cm).

In a number of tests, pressure was exerted on the top surface of the tube at a location separated from the near end. The tube deformed elastically, bringing the locating and source members into contact, and resulting in a reading on the voltmeter from which the location of the pressure point could be calculated.

## CLAIMS

1.   A method for monitoring for the occurrence of an event, and for detecting and obtaining information about the event upon its occurrence, which method comprises providing a system in which, upon occurrence of the event,

(1) electrical connection is made between an electrically conductive locating member and an electrically conductive source member;

the connection to the locating member being effective at a first point whose location is defined by at least one characteristic of the event;

the making of the connection enabling the formation of a test circuit which comprises (a) the connection, (b) that part of the locating member which lies between the first point and a second point having a known location on the locating member, and (c) a power source which causes an electrical current of known size to be transmitted between the first and second points on the locating member; and

the current and the locating member being such that, by measuring the voltage drop between the first and second points, the spatial relationship between the first and second points can be determined;

(2)  the voltage drop between the first and second points is measured; and

(3)  information concerning the event is obtained from the measurement made in step (2).

2.    A method according to claim 1 wherein

    (a)    the locating member and the source member
        are elongate; and

    (b)    the second point is a fixed point at one
        end of the locating member.

3.    A method according to claim 1 or 2 wherein the power
source is a controlled current source which delivers
a known fixed current.

4.    A method according to claim 3 wherein the controlled
current source supplies a known current which is less
than 10 milliamps.

5.    A method according to any one of the preceding
claims wherein the voltage drop between the first and
second points is determined by means of a voltage-
measuring device which forms part of a reference
circuit, the reference circuit comprising

    (a)    the voltage-measuring device,

    (b)    that part of the locating member which lies
        between the first and second points, and

    (c)    an electrically conductive return member which
        (i) is electrically connected to the locating
        member at the ends thereof, and (ii) is
        otherwise insulated from the locating member,

the voltage-measuring device having an impedance which
is very high by comparison with the impedance of the
other components of the reference circuit.

6.  A method according to any one of the preceding claims which also comprises switching the components of the system from a first arrangement in which the second point is at one end of the locating member to a second arrangement in which the second point is at the opposite end of the locating member.

7.  A method according to any one of the preceding claims wherein the connection between the locating member and the source member has a substantial and unknown impedance.

8.  A method according to any one of the preceding claims wherein information concerning the event is obtained in step (3) only when the ratio $V/I$ is within a predetermined range, wherein $V$ is the output voltage of the power source and $I$ is the current in the test circuit.

9.  A method according to claim 8 wherein the power source is a controlled current source which delivers current at a fixed value, and information is obtained in step (3) only when the current between the first and second points is substantially at said fixed value.

10.  A method according to any one of the preceding claims wherein

(a)  the locating member has a total impedance $Z_{total}$; and

the connection to the locating member being effective at a first point whose location is defined by at least one characteristic of the event;

(b)   the test circuit also includes a component
      which

      (i)   is connected in series with that part
            of the locating member between the first
            point and a second point, and

      (ii)  has an impedance substantially equal to
            the difference between $Z_{total}$ impedance
            of that part of the locating member
            between the first point and the second
            point.

11.   A method according to claim 10 wherein the source
member has substantially the same impedance characteristics as the locating member, and said component is a
part of the source member.

12.   A method according to claim 10 or 11 which also
comprises measuring the impedance of the connection
between the locating and source members.

13.   A method according to any one of the preceding
claims wherein the locating member comprises (1) a
plurality of spaced-apart locating zones, each of said
zones providing a series of points to which the connection
can be made, and (2) a plurality of spaced-apart
connection zones which physically separate and electrically connect the locating zones and which cannot become
connected to the source member.

14.  A method according to any one of the preceding claims wherein the locating member has a temperature coefficient of impedance which averages less than 0.003 per degree C over the temperature range 0 to 100°C.

15.  A method according to any one of the preceding claims wherein the locating member comprises

(A)  an elongate core which is composed of a metal whose temperature coefficient of resistivity averages less than 0.003 per degree C over the temperature range 0° to 100°C and in which each longitudinal section has a resistance from $10^{-4}$ to $10^{4}$ ohms/foot; and

(B)  an elongate jacket which is composed of a conductive polymer, which electrically surrounds the core and in which each longitudinal section has a resistance which is at least 100 times the resistance of the core of that longitudinal section at all temperatures from 0° to 100°C.

16.  A method according to any one of the preceding claims wherein (1) at least a part of at least one of the locating and source members comprises an elongate metal core which is electrically surrounded by an elongate jacket composed of a conductive polymer, and (2) the event is the presence of sufficient electrolyte to connect the locating and source members.

17.   A method according to claim 1 wherein the event
is a change in the concentration of a particular
substance, and the locating and source members are
physically contacted by a connecting member which
insulates them from each other prior to said change
and which effects or permits electrical connection
between the locating member and the source member as a
result of said change.

18.   A method according to claim 1 wherein event-
monitoring is required only in spaced-apart zones, and
the locating member comprises (a) a plurality of
spaced-apart locating components which are in said
zones and to which connection is made upon occurrence
of an event, and (b) a plurality of spaced-apart
intermediate components which physically separate and
electrically connect the locating components and which
cannot become directly connected to the source member.

19.   Apparatus suitable for use in the method claimed
in any one of claims 1 to 18, which apparatus comprises

(1)   an elongate locating member whose impedance
from one end to any point thereon defines the
spatial relation ship between that end and that
point;

(2)   an elongate source member;

(3)   an event-sensitive connection means   which,
upon occurrence of an event, effects electrical
connection between the locating member and the
source member, the connection being effective at a
first point on the locating member which is defined
by at least one characteristic of the event;

(4) a voltage-measuring device for determining the voltage drop between the first point and a second point which is at one end of the locating member;

(5) a power source which is electrically connected to the second point on the locating member and, in the absence of an event, is not otherwise connected to the locating member; and

(6) a return member having a first end which is electrically connected to one end of the locating member via the voltage-measuring device and a second end which is electrically connected to the other end of the locating member, the return member being otherwise insulated from the locating member;

whereby upon occurrence of an event which causes an electrical connection between the locating and source members, this enables the formation of the test circuit and a reference circuit which comprises the voltage-measuring device, the locating member, and the return member, the voltage-measuring device having an impedance which is very high by comparison with the impedance of the other components of the reference circuit.

20. Apparatus according to claim 19 wherein the power source is a controlled current source which, when an event occurs, supplies a known fixed current.

21. Apparatus according to claim 19 or 20 which includes means for preventing the display of information about the event if the value of the ratio V/I is outside a predetermined range, wherein I is the output voltage of the power source in volts and I is the current in the test circuit in amps.

22. Apparatus according to any of claims 19 to 21 wherein the source member has the same impedance characteristics as the locating member.

23. An elongate article which is suitable for use as the locating member in a method as claimed in any of claims 1 to 18, said article comprising

(A) an elongate core which is composed of a metal whose temperature coefficient of resistivity averages less than 0.003 per degree Centigrade over the temperature range 0° to 100°C and in which each longitudinal section has a resistance which is from $10^{-4}$ to $10^{4}$ ohms/foot, and

(B) an elongate jacket which is composed of a conductive polymer, which electrically surrounds the core, and in which each longitudinal section has a resistance which is at least 100 times the resistance of the core of that longitudinal section at all temperatures from 0° to 100°C.

24. An article according to claim 23 which has a resistance of 1 to 20 ohm/foot (3.3 to 65 ohm/meter) and a temperature coefficient of resistance which averages less than 0.0003 per degree Centigrade in the temperature range 0° to 100°C.

0253085
MPO869

25. An event-sensitive module which is suitable for use as a component in a method as claimed in claim 10, 11 or 12, the module comprising

(1)  a first impedant component having substantial impedance;

(2)  a first conductor which has a relatively very small impedance and one end of which is connected to the first impedant component;

(3)  a second impedant component having the same impedance as the first impedant component;

(4)  a second conductor which has a relatively very small impedance and one end of which is connected to the second impedant component;

the first impedant component and the first conductor, in the absence of an event, being electrically insulated from the second conductor and the second impedant component; and

(5)  an event-sensitive connection means which, upon occurrence of an event, can effect electrical connection between the first and second conductors;

the first impedant component and the first conductor being connectable in series with incoming and outgoing portions of intermediate components of an elongate locating member, and the second impedant component and the second conductor being connectable in series with incoming and outgoing portions of intermediate components of an elongate source member.

26.  A module according to claim 25 which also comprises
a third impedant component connected to the other end
of the first conductor, and a fourth impedant component
connected to the other end of the second conductor, the
third and fourth components having the same impedance
as the first and second components.

27.  Apparatus which is suitable for use in a method
as defined in claim 8 or 9 and which comprises

        (1)  a first terminal;

        (2)  a second terminal;

        (3) a third terminal;

        (4)  means for connecting the first and second
             terminals to a power source;

        (5)  a voltage-measuring device for measuring the
             voltage drop between the second and third
             terminals;

        (6)  a display unit for displaying information
             derived from a voltage drop measured by the
             voltage-measuring device; and

(7) a device which, when the first and second terminals are connected to a power source and are connected to each other through a locating member and a source member, thus forming a test circuit, prevents the display unit from displaying information if the value of the ratio V/I is outside a predetermined range, where I is the current in the test circuit in amps and V is the output voltage of the power source in volts.

28. Apparatus according to claim 26 which is adapted to be connected to a fixed voltage AC power source and which comprises a constant current source which converts the AC input into a DC current of controlled size, and the device (7) is a current-sensitive device which prevents the display of information if the current in the test circuit falls below the controlled size.

Fig . 1.

0253085

Fig.2.

Fig.3.

Fig.4.

# Fig .5.

# Fig .6 .

4/14

0253085

Fig .7.

Fig .8.

Fig .9.

## Fig.10.

## Fig.11.

## Fig.12.

## Fig . 13.

## Fig . 14.

## Fig . 15.

0253085

**Fig .16 .**

**Fig .17.**

**Fig .18 .**

# Fig . 19.

# Fig . 20.

Fig . 21.

Fig .22.

0253085

9/14

Fig . 23 .

Fig . 24 .

**Fig. 25.**

**Fig. 26.**

**Fig. 27.**

0253085

# Fig. 28.

# Fig. 29.

# Fig. 30.

VOLTAGE DROP

DISTANCE

## Fig . 31.

VOLTAGE DROP

DISTANCE

## Fig . 32.

VOLTAGE DROP

DISTANCE

14/14

0253085

Fig . 33 .

Fig . 34 .

Fig . 35 .

Fig . 36 .

Fig . 37 .

Fig . 38 .

European Patent Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| Y | AT-B- 58 704 (J. STEPHENSON) <br> * page 2, lines 1-29; figure * | 1,9,19 | G 01 R 31/08 <br> G 01 M 3/18 |
| Y,D | US-A-3 800 216 (R.H. HAMILTON) <br> * claim 1; column 2, lines 52-68; figure 1 * | 1,9,19 | |
| A,D | | 3-5 | |
| A,D | US-A-3 991 413 (PH. H. BERGER) <br> * abstract; figures 1,2 * | 1,9,19 | |
| A,D | DE-A-3 225 742 (KUNSTSTOFFWERKE KARL EGGER) <br> * claim * | | |
| A,D | US-A-2 581 213 (D.C. SPOONER) <br><br> * figures 1,2 * | | |

**TECHNICAL FIELDS SEARCHED (Int. Cl 4)**

G 01 M 3/18
G 01 R 19/165
G 01 R 31/02
G 01 R 31/08
G 08 B 17/06

The present search report has been drawn up for all claims

| Place of search | Date of completion of the search | Examiner |
|---|---|---|
| BERLIN | 30-09-1987 | LEMMERICH J |